# EUROPÄISCHE PATENTSCHRIFT

(11) **EP 0 243 637 B1**
(45) Veröffentlichungstag und Bekanntmachung des Hinweises auf die Patenterteilung: **07.01.1993**
(21) Anmeldenummer: 87103618.2
(22) Anmeldetag: 12.03.1987
(51) Int. Cl.: H01L 21/58, H01L 23/34, H01L 23/40

(54) **Leistungshalbleitermodul**
Semi-conductor power module
Module de puissance à semi-conducteur

(30) Priorität: 26.03.1986 DE 3610288
(43) Veröffentlichungstag der Anmeldung: 04.11.1987
(73) Patentinhaber: Asea Brown Boveri Aktiengesellschaft, 68309 Mannheim (DE)
(72) Erfinder: Neidig, Arno, Dr. Dipl.-Phys., D-6831 Plankstadt (DE); Böbinger, Dietrich, Dipl.-Phys., D-6840 Lampertheim (DE)
(74) Vertreter: Rupprecht, Klaus, Dipl.-Ing.

(56) Entgegenhaltungen:
- EP-A- 0 069 901
- DE-A- 3 028 178
- DE-A- 3 323 246
- FR-A- 2 535 898
- US-A- 4 367 523
- (ELECTRONIC COMPONENTS & APPLICATIONS) Band 7, Nr. 4, 1985, Seiten 250-255, Eindhoven, NL; "Insulated encapsulations for easier mointing of power semiconductors"

## Beschreibung

Die Erfindung bezieht sich auf ein Leistungshalbleitermodul mit einem Modulgehäuse und einem als Gehäuseboden eingesetzten Keramiksubstrat nach dem Oberbegriff des Anspruchs 1 und des Anspruchs 5. Zur Verbesserung der Wärmeabfuhr werden solche Module üblicherweise mit einem Kühlkörper in Kontakt gebracht, wofür in der Regel eine Schraubverbindung vorgesehen ist. Leistungshalbleitermodule mit Schraubbefestigung sind in unterschiedlicher Ausführung bekannt z.B. mit außen am Gehäuse angeformten Befestigungsflanschen oder bei rahmenförmigen Gehäusen auch mit einem zentralen Befestigungsteil, das zumindest eine Bohrung für eine Befestigungsschraube aufweist.

Bei allen Ausführungsvarianten treten im Bereich der Befestigungsschrauben erhebliche mechanische Kräfte auf, die such über die im Schraubenbereich befindlichen Gehäuseteile auf das Keramiksubstrat übertragen. Die üblicherweise dünnen und spröden Keramiksubstrate sind daher in hohem Maße bruchgefährdet, insbesondere wenn das zulässige Drehmoment für die Schraubbefestigung über schritten wird. Es können Risse in der Keramik auftreten, die die Isolationsfestigkeit herabsetzen.

Es sind bereits mehrere Vorschläge zur konstruktiven Gestaltung der Module bekanntgeworden, die eine Minderung der Bruchgefahr für das Keramiksubstrat bewirken. Trotzdem besteht weiterhin Bedarf an zusätzlichen oder alternativen Maßnahmen zum Schutz der bruchempfindlichen Keramiksubstrate.

Aus der DE-A-31 27 457 ist ein Leistungshalbleitermodul mit einem Keramiksubstrat als Gehäuseboden bekannt, bei dem das Substrat auf der Unterseite mit einer Kupferfolie versehen ist, und bei dem Flachstecker für Außenanschlüsse einen Dehnungsbogen aufweisen. Damit kann die Gefahr von Keramikbrüchen infolge unebener Kühlkörper bereits wesentlich reduziert werden. Belastungsprobleme durch Übertragung mechanischer Kräfte aus dem Bereich der Befestigungsschrauben sind jedoch damit noch nicht ausreichend gelöst.

Eine weitere wesentliche Verbesserung bringt der Vorschlag gemäß DE-A-33 07 707, nämlich durch Schlitze im Kunststoffgehäuse die Übertragung mechanischer Spannungen zu verringern. Diese Maßnahme läßt sich jedoch nicht bei allen Modulkonstruktionen anwenden, zumindest nicht in einem solchen Umfang, daß eine Kraftübertragung völlig ausgeschlossen wäre. Kaum anwendbar sind solche Schlitze zur mechanischen Entkopplung beispielsweise bei einer Modulgestaltung gemäß DE-A-30 28 178, nämlich einem Modul mit zentralem Befestigungsteil. Um einen gleichmäßigen Andruck des Moduls auf den Kühlkörper zu erreichen, soll nämlich das zentrale Befestigungsteil formstabil mit einem äußeren Rahmen verbunden sein.

Der Erfindung liegt deshalb die Aufgabe zugrunde, für Leistungshalbleiter mit Kunststoffgehäuse und einem Boden aus einem Keramiksubstrat weitere Maßnahmen zur Minderung der Bruchgefahr anzugeben.

Diese Aufgabe wird bei einem Leistungshalbleitermodul nach dem Oberbegriff des Anspruchs 1 durch dessen kennzeichnende Merkmale gelöst sowie bei einem Leistungshalbleitermodul nach dem Oberbegriff des Anspruchs 5 durch die kennzeichnenden Merkmale des Anspruchs 5. Vorteilhafte Ausgestaltungen sind in Unteransprüchen angegeben. Der Oberbegriff des Anspruchs 1 bezieht sich auf das aus der DE-A-30 28 178 bekannte Modul, der Oberbegriff des Anspruchs 5 auf das aus der DE-A-31 27 457 bekannte Modul.

Vorteile der Erfindung bestehen darin, daß die zur mechanischen Verstärkung vorgesehenen Metallisierungsflächen einfach und gleichzeitig mit den übrigen Metallisierungsflächen für elektrische Leitungen hergestellt werden können. Die Lösung ist bei unterschiedlichen Modulausführungen anwendbar. Das Keramiksubstrat kann mit hoher und gleichmäßiger Anpreßkraft auf einen Kühlkörper drücken und wird dabei wirksam vor Rißbildung geschützt.

Die Erfindung wird anhand eines in der Zeichnung dargestellten Ausführungsbeispiels näher erläutert.

Es zeigen:
- Fig. 1: eine Draufsicht auf ein Keramiksubstrat,
- Fig. 1a: eine Ausführungsvariante des Keramiksubstrats,
- Fig. 2: einen Schnitt durch das in Fig. 1 dargestellte Substrat,
- Fig. 3: ein bestücktes Substrat,
- Fig. 4: einen Schnitt durch ein Kunststoffgehäuse mit zentralem Befestigungsteil,
- Fig. 5: eine Explosionsdarstellung der für das in

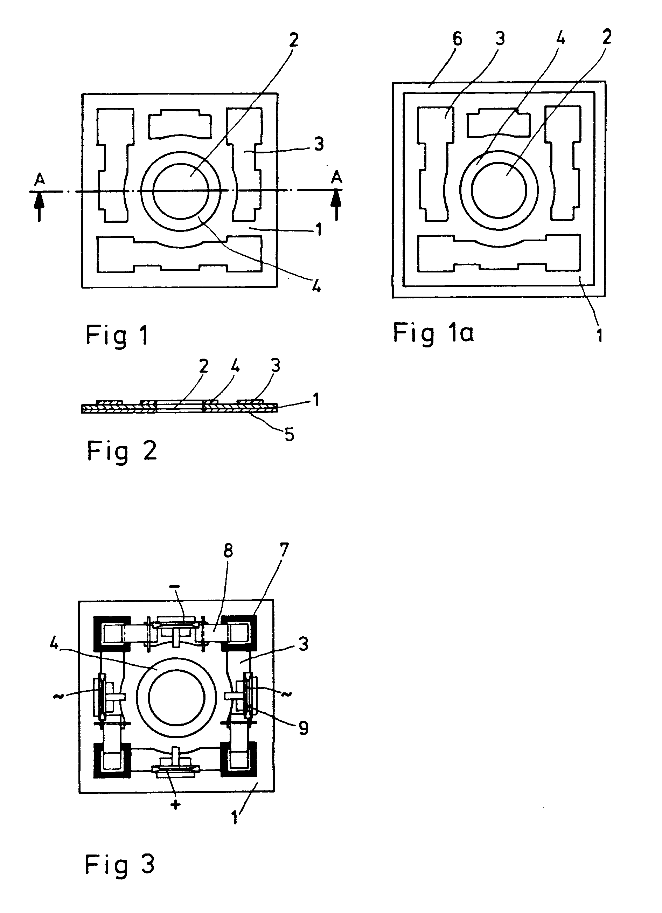

- Fig. 3: dargestellte Substrat benötigten Teile,

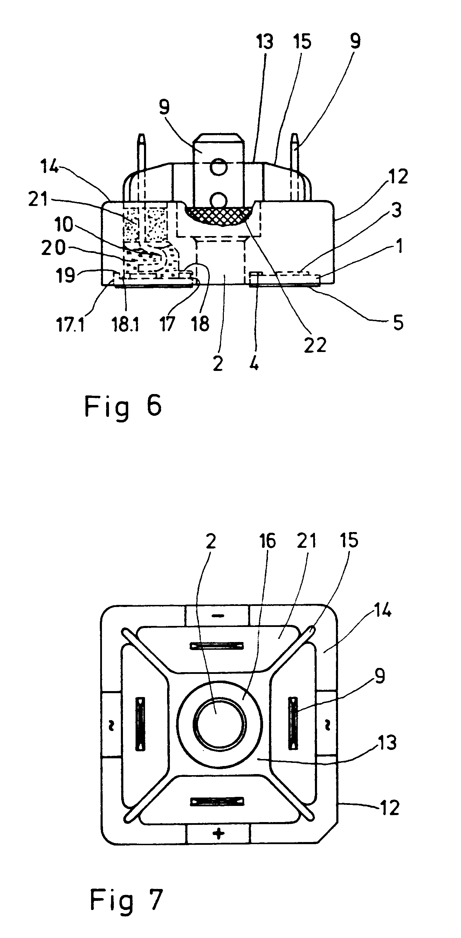

- Fig. 6: eine Seitenansicht eines fertiggestellten Leistungshalbleitermoduls,
- Fig. 7: eine Draufsicht auf das fertiggestellte Leistungshalbleitermodul.

Das Ausführungsbeispiel betrifft ein Leistungshalbleitermodul, das aus der DE-A-30 28 178 bekannt ist. Das Leistungshalbleitermodul hat ein etwa quaderförmiges Kunststoffgehäuse mit einem zentralen Befestigungsteil und hat als Boden ein Keramiksubstrat. Das Modul stellt eine Realisierung einer ungesteuerten einphasigen Gleichrichterschaltung (Graetzbrücke) dar.

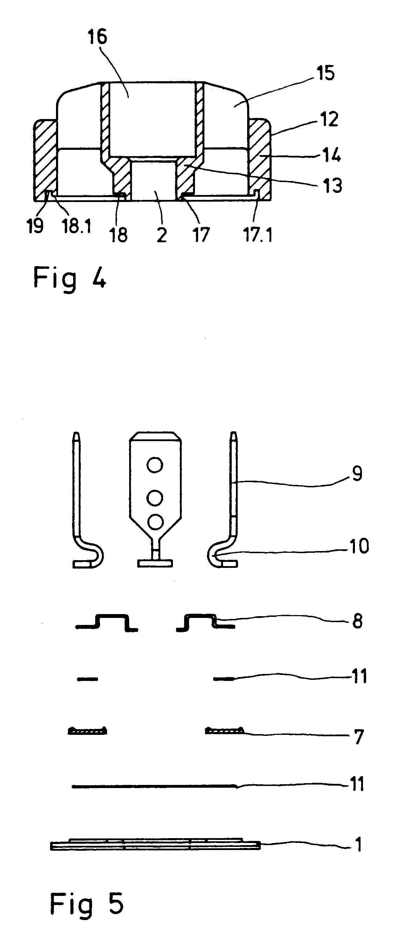

Fig. 1 zeigt eine Draufsicht auf die dem Modulinneren zugewandte Oberseite eines Keramiksubstrats 1, das in ein Gehäuse des aus der DE-A-30 28 178 bekannten Moduls eingesetzt werden kann. Das Substrat 1 besteht vorzugsweise aus 96% Al₂O₃ und weist in der Mitte eine Öffnung 2 zur Durchführung einer Befestigungsschraube auf. Auf der Oberseite des Substrats 1 sind Leiterbahnen 3 sowie im Bereich der Öffnung 2 ein erfindungsgemäßer Verstärkungsring 4 angeordnet. Die Breite des Verstärkungsrings 4 beträgt z.B. 2mm und entspricht etwa einer Auflagefläche 18 in einer Ausnehmung 17 eines zentralen Befestigungsteils 13 eines Gehäuses 12, das in Fig. 4 dargestellt ist. Der Abstand des Verstärkungsrings 4 zum inneren Metallisierungsmuster, also zu den Leiterbahnen 3, ist so bemessen, daß die Isolationsfestigkeit der inneren Schaltung nach außen zu einem Kühlkörper nach dem Vergießen des Moduls mit Vergußmasse gewährleistet ist. Es ist zu beachten, daß der Abstand zwischen dem Verstärkungsring 4 und einer Kupferschicht 5 (siehe Fig. 2) auf der Unterseite des Keramiksubstrats, also die durch die Dicke des Keramiksubstrats gegebene Strecke zwischen Verstärkungsring 4 und Kupferschicht 5 an der Kante der Öffnung 2 im allgemeinen nicht als Isolationsstrecke wirken kann, da die Keramik an dieser Stelle nicht mit Vergußmasse bedeckt ist. Auch zwischen dem Außenrand des Keramiksubstrats 1, auf den sich ein äußerer Rahmen 14 des Gehäuses 12 (siehe Fig. 6) abstützt und den Leiterbahnen 3 muß ein Isolationsrand eingehalten werden. Die minimalen Abstände, die zwischen Metallisierungsflächen (Leiterbahnen 3, Verstärkungsring 4) einzuhalten sind, richten sich nach den einzuhaltenden Sperrspannungen, nach der Isolationsfestigkeit der Vergußmasse und schließlich nach dem Auflösungsvermögen der angewendeten Maskier- und Ätztechnik (z.B. Siebdruckverfahren).

Es ist zweckmäßig, die Leiterbahnen 3 und den Verstärkungsring 4 auf der Oberseite des Keramiksubstrats 1 durch direktes Verbinden (direct-bonding-Verfahren) einer 0,1 bis 0,5 mm, bevorzugt 0,3 mm dicken Kupferfolie mit dem Keramiksubstrat 1 herzustellen, und zwar durch Verwendung einer ganzflächig die Oberseite des Substrats 1 bedeckenden Folie, die anschließend geätzt wird. Zur Herstellung der Kupferschicht 5 auf der Unterseite des Substrats 1 wird zweckmäßig eine Kupferfolie verwendet, die etwa gleich dick ist wie die für die oberseitige Metallisierung benutzte Folie und in die bereits ein der Öffnung 2 entsprechendes Loch gestanzt ist. Die Unterseite des Substrats 1 braucht dann nicht mehr geätzt zu werden.

Die Kupferflächen des so metallisierten Substrats werden anschließend zweckmäßig chemisch vernickelt und für den anschließenden Lötprozeß vorbereitet.

Fig. 2 zeigt einen Schnitt durch die in Fig. 1 eingetragene Schnittebene A-A des Substrats 1. Daraus ist ersichtlich, daß auf der Unterseite des Keramiksubstrats 1 eine Kupferschicht 5 vorgesehen ist, die etwa die gleiche Dicke wie der Verstärkungsring 4 hat und zweckmäßig ebenfalls direkt mit dem Substrat 1 verbunden ist. Der Verstärkungsring 4 und die Kupferschicht 5 haben keine elektrische Funktion. Sie dienen ausschließlich zur mechanischen Verstärkung des Substrats 1 und bewirken in ihrer Kombination eine wesentliche Herabsetzung der Bruchgefahr im Vergleich zur bekannten Substratausführung.

Selbstverständlich kann die Erfindung in entsprechender Weise für größere Module angewendet werden, die mit mehreren Schrauben befestigt werden.

Bei besonders formstabilen Kunststoffgehäusen, z.B. aus duroplastischen Polyestern mit Glasfaserverstärkung, kann es erforderlich sein, auch den äußeren Rand, auf dem das Gehäuse ebenfalls aufliegt, besonders zu schützen. Dazu kann, wie in Fig. 1a dargestellt, ein äußerer Verstärkungsring 6 auf dem Keramiksubstrat 1 vorgesehen werden, der in gleicher Weise wie der Verstärkungsring 4 im Bereich der Öffnung 2 gestaltet und hergestellt wird. Dabei kann es erforderlich sein, die Fläche des Keramiksubstrats 1 etwas zu vergrößern, da bestimmte Abstände zwischen den Leiterbahnen 3 und dem äußeren Verstärkungsring 6 bzw. dem Verstärkungsring 4 im Bereich der Öffnung 2 im Hinblick auf die notwendigen Isolationsstrecken einzuhalten sind. Selbstverständlich ist in diesem Fall das Gehäuse 12 im Bereich seiner zweiten Auflagefläche 18.1 in der zweiten Ausnehmung 17.1 des Rahmens 14 entsprechend anzupassen (vgl. Fig. 4 und zugehörige Beschreibung).

Bei anderen Modulgestaltungen, die nicht in der Zeichnung dargestellt sind, also z.B. bei Verwendung eines Modulgehäuses mit außen angeformten Befestigungsflanschen, kann zum Schutz eines in die Bodenfläche eingesetzten Keramiksubstrats ebenfalls ein äußerer Verstärkungsring auf dem Substrat vorgesehen werden. Beispielsweise könnte ein solcher äußerer Verstärkungsring vorteilhaft bei einem Modul gemäß DE-OS 31 27 457 vorgesehen werden.

Fig. 3 zeigt die Oberseite des in den Figuren 1 und 2 dargestellten Substrats 1, nachdem es mit Bestückungselementen verlötet ist. Zur Herstellung der dargestellten Gleichrichterschaltung werden auf das Keramiksubstrat 1 vier Diodenchips 7, vier Clips 8 aus Kupfer als modulinterne Verbindungselemente zwischen den Anoden der Chips 7 und den Leiterbahnen 3 und vier Flachstecker 9 als Außenanschlüsse mit einem Weichlot mit einem Schmelzpunkt um 300°C flußmittelfrei aufgelötet. Die vorgesehenen glaspassivierten Diodenchips 7 werden mit den Anoden nach oben auf das Substrat 1 gelötet, so daß der Passivierungsbereich der Dioden 7 oben liegt. Selbstverständlich könnten stattdessen auch planar passivierte Diodenchips verwendet werden.

Fig. 5 zeigt die einzelnen Teile, die zur Herstellung des in Fig. 3 dargestellten fertigbestückten Substrats 1 benötigt werden. Daraus ist ersichtlich, daß die Flachstecker 9 an ihrem Fußpunkt einen Dehnungsbogen 10 aufweisen und daß das Weichlot vorteilhaft als Lotfolie 11 aufgebracht wird.

Fig. 4 zeigt das Gehäuse 12, in das das fertiggelötete Substrat 1 eingeklebt wird. Das Gehäuse 12 weist einen äußeren Rahmen 14 und einen zentralen Befestigungsteil 13 auf, der über Rippen 15 starr mit dem Rahmen 14 verbunden ist. Es besteht aus einem glasfaserverstärkten Kunststoff, der dem Druck einer Befestigungsschraube auch bei Erwärmung ausreichend Widerstand bietet um die Befestigung während eines langjährigen Betriebes zu gewährleisten. Die Rippen 15 und der zentrale Befestigungsteil 13 sind so ausgeführt, daß sie zugleich als Verlängerungswege zur Einhaltung der erforderlichen Kriech- und Luftstrecken wirken. Das zentrale Befestigungsteil 13 ist deshalb relativ hoch ausgeführt, mit einer Vertiefung 16 zur Aufnahme des Schraubenkopfes.

Das zentrale Befestigungsteil 13 weist auf seiner Unterseite eine Ausnehmung 17 mit einer Auflagefläche 18 für das metallisierte Substrat 1 auf. Auch der äußere Rahmen 14 des Gehäuses 12 weist auf seiner Unterseite eine zweite Ausnehmung 17.1 mit einer zweiten Auflagefläche 18.1 auf. In der zweiten Ausnehmung 17.1 ist außerdem eine Nut 19 zur Aufnahme von überschüssigem Klebstoff vorgesehen.

Fig. 6 zeigt in Seitenansicht das fertige Modul nachdem das bestückte Substrat 1 in das Gehäuse 12 mit einem elastischen elektrisch isolierenden Klebstoff eingeklebt ist. Klebestelle ist sowohl die Auflagefläche 18 am zentralen Befestigungsteil 13 als auch die zweite Auflagefläche 18.1 am äußeren Rahmen 14 des Gehäuses 12. Bei Temperaturwechseln entlastet die elastische Klebung das Substrat 1 vom Gehäuse 12. Das Modul wird mit einer weichen elastomeren Vergußmasse 20 (vorzugsweise ein Silicon-Elastomer) hoher Reinheit vergossen, die die in Fig. 6 nicht sichtbaren empfindlichen Chips 7 und die Lötverbindungen der Clips 8 vor mechanischen Spannungen schützt. Die genannte hohe Reinheit der Vergußmasse 20 ist erforderlich um schädliche Ionen von den Chips 7 fernzuhalten und um die Isolationsfestigkeit sicherzustellen. Die Vergußhöhe wird dabei so eingestellt, daß die Dehnungsbogen 10 der Flachstecker 9 vollständig in die Vergußmasse 20 eintauchen. Schließlich wird das Modul mit einer duroplastischen Hartvergußmasse 21, vorzugsweise ein Epoxidharz, bis zu einer Füllhöhe 22 unterhalb der Oberkante des äußeren Rahmens 14 zur Abdichtung nach oben aufgefüllt. Dabei werden die Flachstecker 9 in ihrer Lage fixiert.

Fig. 7 zeigt schließlich eine Draufsicht auf das fertige Modul. Die angegebenen Bezugszeichen sind bereits alle in der vorstehenden Beschreibung erwähnt.

## Patentansprüche

1. Leistungshalbleitermodul mit einem Kunststoffgehäuse (12) und einem als Gehäuseboden eingesetzten Keramiksubstrat (1), das auf der dem Modulinneren zugewandten Oberseite mit Leiterbahnen (3) versehen ist, auf die Halbleiterbauelemente (7), Anschlußelemente (9) und interne Verbindungselemente (8) gelötet sind, wobei zur Schraubbefestigung ein zentraler Befestigungsteil (13) im Kunststoffgehäuse (12) mit mindestens einer durch das Befestigungsteil (13) und das Keramiksubstrat (1) durchgehenden Bohrung (2) vorgesehen ist, dadurch gekennzeichnet, daß die Unterseite des Keramiksubstrats (1) mit einer Kupferschicht (5) versehen ist und daß auf der Oberseite des Keramiksubstrats (1) im Bereich der Auflagefläche (18) des zentralen Befestigungsteils (13) ein Verstärkungsring (4) aus einer Kupferschicht vorgesehen ist.

2. Leistungshalbleitermodul nach Anspruch 1, dadurch gekennzeichnet, daß auf dem Keramiksubstrat (1) zusätzlich ein äußerer Verstärkungsring (6) aus Kupfer im Bereich der Auflagefläche (18.1) eines äußeren Rahmens (14) des Gehäuses (12) vorgesehen ist.

3. Leistungshalbleitermodul nach Anspruch 1 oder 2, dadurch gekennzeichnet, daß alle Kupferschichten (3,4,5,6) aus einer Kupferfolie mit 0,1mm bis 0,5mm, bevorzugt 0,3mm, Dicke bestehen.

4. Leistungshalbleitermodul nach einem der Ansprüche 1 bis 3, dadurch gekennzeichnet, daß die Kupferschichten (3,4,5,6) durch direktes Verbinden einer Kupferfolie mit dem Keramiksubstrat (1) hergestellt sind.

5. Leistungshalbleitermodul mit einem Kunststoffgehäuse mit angeformten Befestigungsflanschen, mit einem Keramiksubstrat als Gehäuseboden, wobei das Substrat auf der Unterseite eine Metallbeschichtung trägt, dadurch gekennzeichnet, daß auf der Oberseite des Keramiksubstrats im Bereich der Auflagefläche des Gehäuses ein Verstärkungsring aus einer 0,1 bis 0,5mm dicken Kupferfolie aufgebracht ist.

## Claims

1. Power semiconductor module having a plastic housing (12) and a ceramic substrate (1) inserted as housing base which is provided on the top side facing the interior of the module with conductor tracks (3), onto which the semiconductor components (7), connecting elements (9) and internal connecting elements (8) are soldered, in which a central fastening member (13) in the plastic housing (12) having at least one bore (2) passing through the fastening member (13) and the ceramic substrate (1) is provided for screw fastening, characterised in that the underside of the ceramic substrate (1) is provided with a copper layer (5), and in that a reinforcement ring (4) made of a copper layer is provided on the top side of the ceramic substrate (1) in the region of the contact area (18) of the central fastening member (13).

2. Power semiconductor module according to Claim 1, characterised in that an outer reinforcement ring (6) made of copper is additionally provided on the ceramic substrate (1) in the region of the contact area (18.1) of an outer frame (14) of the housing (12).

3. Power semiconductor module according to Claim 1 or 2, characterised in that all copper layers (3, 4, 5, 6) are composed of a copper film of 0.1 mm to 0.5 mm, preferably 0.3 mm, thickness.

4. Power semiconductor module according to one of Claims 1 to 3, characterised in that the copper layers (3, 4, 5, 6) are produced by direct bonding of a copper film to the ceramic substrate (1).

5. Power semiconductor module having a plastic housing with formed-on fastening flanges, with a ceramic substrate as housing base, the substrate bearing a metal coating on the underside, characterised in that a reinforcement ring composed of a 0.1 to 0.5 mm thick copper film is applied to the top side of the ceramic substrate in the region of the contact area of the housing.

## Revendications

1. Module semiconducteur de puissance comportant un boîtier en matière plastique (12) et un substrat en céramique (1) servant de fond de boîtier, ce susbstrat présentant, sur sa face supérieure tournée vers l'intérieur du module, des pistes conductrices (3) sur lesquelles les éléments semiconducteurs (7), les éléments de raccordement (9) et les éléments de connexion internes (8) sont soudés, une partie fixation centrale (13), pour fixation par vis, pourvue d'un trou (2) qui traverse ladite partie fixation (13) et le substrat en céramique (1), étant prévue dans le boîtier en matière plastique (12), caractérisé par le fait que la face inférieure du susbstrat en céramique (1) est pourvue d'une couche de cuivre (5) et qu'un anneau de renforcement (4) fait d'une couche de cuivre est prévu sur la face supérieure du substrat en céramique (1), dans la région de la surface d'appui (18) de la partie fixation centrale (13).

2. Module semiconducteur de puissance selon revendication 1, caractérisé par le fait qu'un anneau de renforcement (6) extérieur en cuivre est prévu en plus, sur le substrat en céramique (1), dans la région de la surface d'appui (18.1) d'un cadre extérieur (14) du boîtier (12).

3. Module semiconducteur de puissance selon revendication 1 ou 2, caractérisé par le fait que toutes les couches de cuivre (3, 4, 5, 6) sont en feuille de cuivre épaisse de 0,1 mm à 0,5 mm, de préférence 0,3 mm.

4. Module semiconducteur de puissance selon l'une des revendications 1 à 3, caractérisé par le fait que les couches de cuivre (3, 4, 5, 6) sont réalisées par liaison directe d'une feuille de cuivre au substrat en céramique (1).

5. Module semiconducteur de puissance comportant un boîtier en matière plastique doté de brides de fixation venues de moulage, et un substrat en céramique servant de fond de boîtier, ce substrat portant sur sa face inférieure un revêtement métallique, caractérisé par le fait qu'un anneau de renforcement en feuille de cuivre épaisse de 0,1 à 0,5 mm est appliqué sur la face supérieure du substrat en céramique, dans la région de la surface d'appui du boîtier.
